# EUROPEAN PATENT APPLICATION

(11) **EP 2 453 473 A1**
(43) Date of publication of application: **16.05.2012**
(21) Application number: 10797040.2
(22) Date of filing: 28.06.2010
(51) Int. Cl.: H01L 21/673, B65D 85/86

(54) **SUBSTRATE-STORING CONTAINER**

(30) Priority: 09.07.2009 JP 2009162359
(71) Applicant: Shin-Etsu Polymer Co. Ltd., Tokyo 101-0041 (JP)
(72) Inventor: MASUKO Hidehiro, Saitama-shi Saitama 331-0811 (JP); MIMURA Hiroshi, Saitama-shi Saitama 331-0811 (JP); OGAWA Osamu, Saitama-shi Saitama 331-0811 (JP)
(74) Representative: Giovannini, Francesca
(86) International application number: PCT/JP2010/060989
(87) International publication number: WO 2011/004729

(57) **Abstract**

To provide an inexpensive substrate storing container that can reduce hygroscopicity and moisture permeability and prevent substrates from organic contamination.

The substrate storing container includes a front open box-type container body 1 accommodating a multiple number of semiconductor wafers in alignment and a door 20 detachably fitted to an open front 6 of this container body 1 with a sealing gasket in-between. These container body 1 and door 20 are separately injection-molded of molding material containing synthetic resin having a water absorption of 0.1 % or lower and outgassing in a total amount of 15 ppm or lower when measured after a 24 hour heating at 80 deg. C by the dynamic headspace technique. The synthetic resin of the molding material is specified to be at least one kind selected from cycloolefin polymer, liquid crystal polymer, polyetheretherketone, polybutylene terephthalate and polyethylene terephthalate, or an alloy resin of these.

## Description

### Technical Field

The present invention relates to a substrate storing container for use in storing, preserving, carrying and shipping substrates such as semiconductor wafers, glass masks and the like.

### Background Art

Though not illustrated, a conventional substrate storing container includes a front open box type container body for accommodating a plurality of semiconductor wafers in alignment and a door that is detachably fitted to the open front of the container body with a sealing gasket interposed therebetween, and is mounted on a door opening and closing apparatus or the like attached to a semiconductor processing machine.

A semiconductor wafer is formed with predetermined circuit patterns and cut by dicing into multiple semiconductor chips. The container body and door are separately inj ection-molded of predetermined molding mate rial including synthetic resin. Arrayed vertically on both sides in the interior part of the container body are plural pairs of left and right supporting pieces for supporting semiconductor wafers horizontally.

The thus configured substrate storing container is handled so that after removal of the door by the door opening and closing apparatus, semiconductor wafers are taken out by a special robot from the container body, or after hermetically fitting of the door to the open front of the container body that has semiconductor wafers accommodated therein, air inside the container body is purged by an inert gas or the like.

By the way, miniaturization of semiconductor parts and narrower pitches of lines have proceeded recent years. On the basis of this trend, the substrate storing containers are demanded to have a higher hermiticity and automation in handling from the viewpoint of protecting semiconductor wafers from contamination. Further, in order to suppress exertion of harmful effect on semiconductor wafers due to outgassing and/or dissolution of ions from the container body and door, suitable molding material is selected and the container body and door are cleaned by gas-purging.

In view of the above, as the suitable molding material of the container body, high purity polycarbonate with low additives is used while polybutylene terephthalate and/or polyether etherketone are used as the molding material of the component parts to be attached to the container body (see patent documents 1 and 2).

### Prior Art Documents

### Patent Documents

Patent Document 1:
   Japanese Patent Application Laid-open H10-211686 Patent Document 2:
   Japanese Patent Application Laid-open 2004-146676

### Summary of the Invention

### Problems to be solved by the Invention

The conventional substrate storing container is configured as above, and its container body is formed of a high purity polycarbonate, but there is still the fear that when the minimum line width in processing semiconductor chips is 45 nm or lower, copper interconnection is corroded due to hydroscopic properties of polycarbonate and/or basic organic matter resulting from hydrolysis of organic matter is deposited on semiconductor wafers at the stages of copper interconnection processing and an aluminum vapor deposition process for semiconductor wafers, resultantly lowering production yield.

As a means for solving the problem, there is a method of purging air in the substrate storing container with an inert gas or dry air. However, since polycarbonate has a water absorption of 0.25%, which is rather high, this method can only maintain a low humidity state due to air purging, in less than some tens of minutes so that a lasting effect cannot be expected. In view of this respect, a method of continuously supplying an inert gas or dry air to the substrate storing container has been investigated. However, this method uses a large amount of expensive inert gas or dry gas, hence posing a problem of increasing costs.

Further, there are cases where thermally processed semiconductor wafers are stored after cooling in the container body of the substrate storing container. At this time, the contact part such a supporting piece of the container body that is put in contact with the semiconductor wafer may deform, or the part of the container body that is low in heat resistance may be deformed due to built-up heat in the substrate storing container, giving rise to a fear of reducing the sealing performance of the front of the container body. As a result, occurrence of a situation in which expected effect frompurging of air inside the substrate storing container with an inert gas or dry air cannot be obtained is expected.

The present invention has been devised in view of the above, it is therefore an object of the present invention to provide an inexpensive substrate storing container that can reduce hygroscopicity and moisture permeability, hence prevent substrates from organic contamination. It is another object to provide a substrate storing container that can maintain the effect of air purging for a long period of time. Means for Solving the Problems

In order to solve the above problems, the present invention resides in a substrate storing container comprising: a container body for accommodating substrates; and a door that is detachably fitted to an opening of the container body with a gasket interposed therebetween, the container body and door being separately formed of molding material containing synthetic resin having a water absorption of 0.1% or lower and outgassing in a total amount of 15 ppm or lower when measured after a 24 hour heating at 80 deg. C by the dynamic headspace technique, **characterized in that**
the synthetic resin in the molding material is at least one kind selected from cycloolefin polymer, liquid crystal polymer, polyetheretherketone, polybutylene terephthalate and polyethylene terephthalate, or an alloy resin of these.

Here, when air inside the container body with the door fitted to the opening is purged so as to make the relative humidity 5% or lower, the state in which the relative humidity is 5% or lower can be maintained for two hours or longer.
Further, the heat distortion temperature of the synthetic resin of the molding material may be specified to be 120 deg.C or higher.

Also, the substrate storing container may further include a supporting structure disposed in the container body for supporting substrates, the supporting structure may be formed of molding material containing synthetic resin having a heat distortion temperature of 120 deg.C or higher and a water absorption of 0.1 % or lower, and the synthetic resin of the molding material may be composed of at least one kind selected from cycloolefin polymer, liquid crystal polymer, polyetheretherketone, polybutylene terephthalate and polyethylene terephthalate, or an alloy resin of these.

The substrate storing container may further include a bottom plate attached at the bottom of the container body, part of the opening and closing valve may be formed of molding material containing synthetic resin having a heat distortion temperature of 120 deg.C or higher and a water absorption of 0.1 % or lower, and the synthetic resin of the molding material may be composed of at least one kind selected from cycloolefin polymer, liquid crystal polymer, polyetheretherketone, polybutylene terephthalate, polyethylene terephthalate and polyphenylene sulfide or an alloy resin of these.

The substrate storing container may further include opening and closing valves for air purging, attached to the container body, part of the opening and closing valve may be formed of molding material containing synthetic resin having a heat distortion temperature of 120 deg.C or higher and a water absorption of 0.1% or lower, and the synthetic resin of the molding material may be composed of at least one kind selected from cycloolefin polymer, liquid crystal polymer, polyetheretherketone, polybutylene terephthalate, polyethylene terephthalate and polyphenylene sulfide or an alloy resin of these.

Further, it is preferable that the door has a substrate holding retainer attached thereto, the retainer is formed of molding material containing synthetic resin having a heat distortion temperature of 120 deg.C or higher and a water absorption of 0.1 % or lower, and the synthetic resin of the molding material is composed of at least one kind selected from cycloolefin polymer, liquid crystal polymer, polyetheretherketone, polybutylene terephthalate and polyethylene terephthalate, or an alloy resin of these.

Here, the substrates defined in the scope of the claims may at least include semiconductor wafers, liquid crystal substrates, glass masks and the like of various sizes (e.g., φ200, 300, 450 mm, etc.). A single or a plurality of substrates may be considered. The container body may be given in any form of a front open box type, top open box type or bottom open box type.

The dynamic headspace technique (also called purge-and-trap technique)is one kind of head space techniques, and generally refers to a testing method of evaluating the chemical substances emanated from the specimen under the airflow of a gas such as air, nitrogen or the like, by gas chromatography(GC). Further, other than the synthetic resin, the molding material is added with appropriate fillers to improve rigidity, conductivity, incombustibility, etc.

In view of preventing adherence of particles and organic matter to the substrates, as to the substrate storing container according to the present invention, when the total quantity of outgas arising during heating synthetic resin pellets at 80 deg.C for 60 minutes is measured by the dynamic headspace technique, the total amount of outgas is specified to be 15 ppm or lower, preferably 10 ppm or lower. Further, as to the sealability of the substrate storing container according to the present invention, when the substrate storing container is set in an airtight chamber and these are decompressed to -0.3 kPa and -30 kPa, respectively and left alone, it is preferable that the decompressed state can be maintained for 2 hours or longer.

According to the present invention, the molding material of the substrate storing container contains a synthetic resin having a water absorption of 0.1 % or lower and outgassing in a total amount of 15 ppm or lower when measured after a 24 hour heating at 80 deg.C by the dynamic headspace technique, and the synthetic resin is specified to be at least one kind selected from cycloolefin polymer, liquid crystal polymer, polyetheretherketone, polybutylene terephthalate and polyethylene terephthalate, or an alloy resin of these. It is hence possible to keep the humidity inside the substrate storing container low. Accordingly, it is possible to suppress contamination of the substrates stored in the container body and prevent circuit patterns etc. on the substrates from being corroded.

### Effect of the Invention

The present invention is effective in providing an inexpensive substrate storing container that can reduce hygroscopicity and moisture permeability, hence preventing substrates from organic contamination.
Further, since it is possible to suppress lowering of sealability of the container body when the heat distortion temperature of the synthetic resin of the molding material is specified to be 120 deg.C or higher, it is possible to maintain the effect of air replacement in the substrate storing container for long period of time.

When the supporting structure is formed of molding material containing synthetic resin having a heat distortion temperature of 120 deg.C or higher and a water absorption of 0.1 % or lower, and the synthetic resin of the molding material is specified to be at least one kind selected from cycloolefin polymer, liquid crystal polymer, polyetheretherketone, polybutylene terephthalate and polyethylene terephthalate, or an alloy resin of these, the substrates can be held safely on the supporting pieces, it hence is possible to prevent displacement of substrates as well as to prevent generation of dirt and dust that would exert adverse influence on the substrates. It is also possible to maintain the state in which the relative humidity inside the substrate storing container is 5 % or lower for one hour or longer.

When part of the opening and closing valve for air replacement is formed of molding material containing synthetic resin having a heat distortion temperature of 120 deg.C or higher and a water absorption of 0.1% or lower and the synthetic resin of the molding material is specified to be at least one kind selected from cycloolefin polymer, liquid crystal polymer, polyetheretherketone, polybutylene terephthalate, polyethylene terephthalate and polyphenylene sulfide or an alloy resin of these, it is possible to keep the state in which the relative humidity inside the substrate storing container is 5 % or lower, for one hour or longer.

Further, when the retainer for supporting substrate is formed of molding material containing synthetic resin having a heat distortion temperature of 120 deg.C or higher and a water absorption of 0.1 % or lower, and the synthetic resin of the molding material is specified to be at least one kind selected from cycloolefin polymer, liquid crystal polymer, polyetheretherketone, polybutylene terephthalate and polyethylene terephthalate, or an alloy resin of these, it is possible to keep the state in which the relative humidity inside the substrate storing container is 5 % or lower for one hour or longer.

### Brief Description of the Drawings

[FIG. 1] is a perspective illustrative view schematically showing an embodiment of a substrate storing container according to the present invention.
[FIG. 2] is a perspective illustrative view schematically showing, from the bottom side, an embodiment of a substrate storing container according to the present invention.
[FIG. 3] is a sectional illustrative view schematically showing an embodiment of a substrate storing container according to the present invention.
[FIG. 4] is an illustrative top view schematically showing a door in an embodiment of a substrate storing container according to the present invention.
[FIG. 5] is an illustrative side view schematically showing a door in an embodiment of a substrate storing container according to the present invention.

### Mode for Carrying Out the Invention

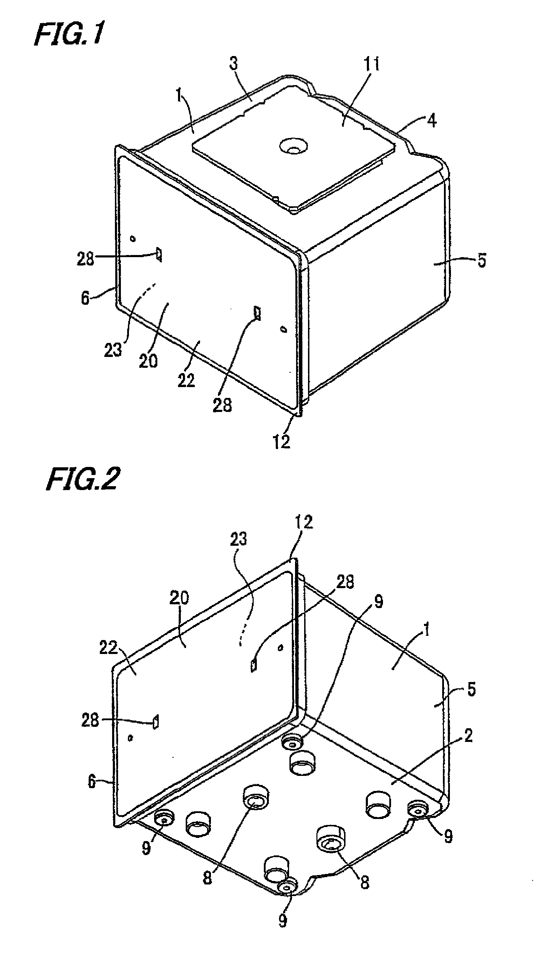

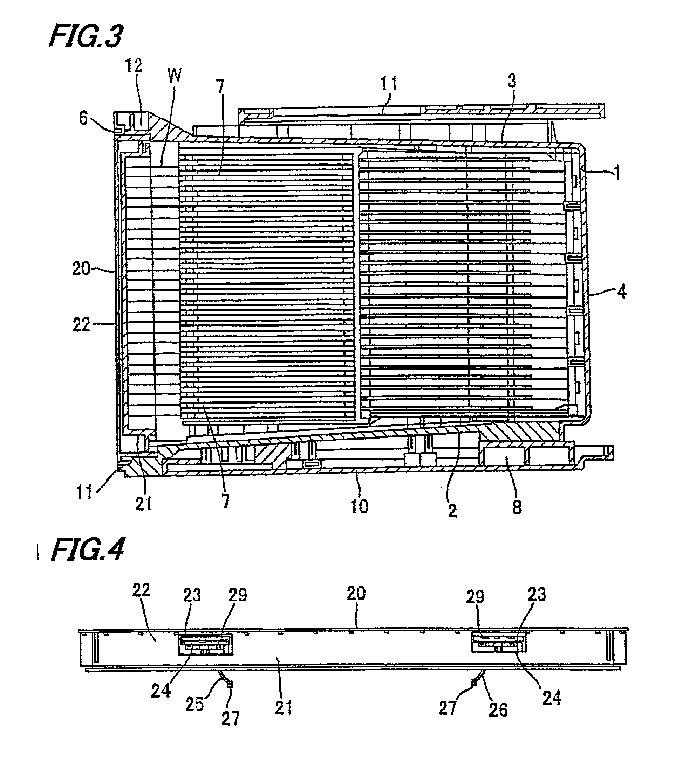

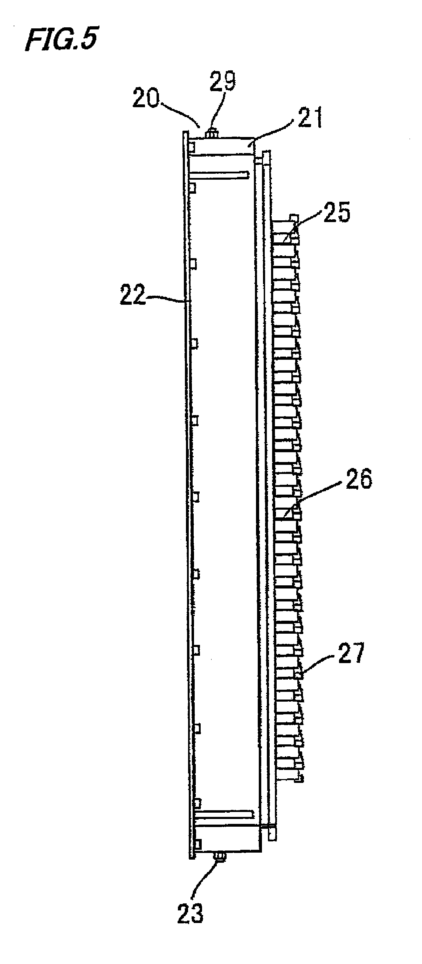

Now, a preferred embodiment mode of the present invention will be described with reference to the drawings. As shown in FIGS. 1 to 5, the present embodiment includes a container body 1 capable of accommodating a plurality of semiconductor wafers W in alignment and a door 20 fitted to an open front 6 of this container body 1 with a sealing gasket in-between. These container body 1 and door 20 are separately injection-molded of molding material containing synthetic resin having a water absorption of 0.1% or lower and outgassing in a total amount of 15 ppm or lower. When air inside container body 1 with door fitted to open front 6 is purged with an inert gas such as nitrogen gas or the like so as to make the relative humidity 5% or lower, the state in which the relative humidity is 5% or lower is adapted to be able to be maintained for two hours or longer.

Semiconductor wafer W is, for example, a thin sliced, round silicon wafer having a diameter of 300 mm, is formed on its surface with predetermined circuit patterns, and cut into multiple semiconductor chips by dicing in a dicing process. The rear side of this semiconductor wafer W is background in order to make for thinning of semiconductor packages.

As shown in FIGS. 1 to 3, container body 1 is given as a front-open box type molding having a bottom plate 2 greater than semiconductor wafer W, a top plate 3 opposing this bottom plate 2 from the top in the accommodating space of semiconductor wafers W, a rear side wall 4 vertically joins between rear parts of these bottom plate 2 and top plate 3 and a pair of left and right side walls 5 vertically join between the sides of bottom plate 2 and top plate 3 on both left and right sides. The container body is positioned and mounted with its laterally long open front 6 oriented horizontally sidewards, on a door opening and closing apparatus attached to a semiconductor processing machine.

Provided on both sides of the interior of container body 1, or on the inner surface of both side walls 5, are a pair of left and right supporting pieces 7 as a supporter for horizontally supporting semiconductor wafer W. A plurality of the paired supporting pieces 7 are arrayed vertically with a predetermined pitch, each supporting piece being extended in a front-and-rear direction of container body 1 so as to come into contact with the peripheral edge at side on the undersurface of semiconductor wafer W.

Positioning tools 8 for positioning the container body relative to the positioning pins of the door opening and closing apparatus are attached at the front and rear on bottom plate 2 of container body 1. A round passage-hole is formed at each of the four corners of bottom plate 2. An opening and closing valve 9 for purging air inside the substrate storing container with an inert gas or the like is removably fitted to each passage hole via an O-ring.

Opening and closing valve 9 includes a cylindrical valve body to be fitted into the passage hole in bottom plate 2 of container body 1. This valve body has a valve element that opens and closes a flow path, inserted therein and supported in a vertically movable manner by means of an elastic member such as a coil spring etc. Fitted over the open top or bottom of the valve body is a filter for filtering a gas. Opening and closing valves 9 of this kind are attached as an inlet filter to each passage hole at the rear part of bottom plate 2 and also attached as an outlet filter to each passage hole at the front part of bottom plate 2, being connected to an air purging apparatus or the like, so as to purge air inside container body 1 with nitrogen gas and thereby provide a function of preventing the surface of semiconductor wafers W from being oxidized, etc.

A bottom plate 10 that covers bottom plate 2 while exposing multiple positioning tools 8 and opening and closing valves 9, is optionally screwed to bottom plate 2 of container body 1 by fastening screws. This bottom plate 10 is given in a form having a similar shape marginally smaller than bottom plate 2 with its periphery made standing up for reinforcement. A pair of conveyor rails for conveyance are optionally formed on both sides.

robotic flange 11 to be held for automatic conveyance is detachably attached around the center of top plate 3 of container body 1. In the front 6 of container body 1, a rim flange 12 that extends outwards of the periphery is formed in a projective manner. Removable door 20 is fitted into this rim flange 12 by the door opening and closing apparatus. A transparent inspection window is optionally formed in the center of rear side wall 4 of container body 1. The interior of container body 1 can be visually observed and grasped through this inspection window.

As shown in FIGS. 1, 4 and 5, door 20 is formed of a casing 21 that is laterally long when viewed from the front and removably fitted to open front 6 of container body 1, a front plate 22 that covers the open front 6 of this casing 21 and a locking mechanism 23 that is located between the casing 21 and front plate 22.

Casing 21 is given as an approximately dish-like form with a shallow bottom in section, basically having a frame-like peripheral wall while the central part is projectively formed in an approximately box-like shape from the rear side to the front side when viewed from the front so as to section fitting spaces for locking mechanism 23 with multiple screw bosses between the central part and the peripheral walls on both left and right sides. Passage holes 24 for locking mechanism 23 are formed at top and bottom of the peripheral wall of this casing 21 on both sides. Each passage hole 24 opposes an engagement hole bored in the inner peripheral surface of rim flange 12.

Removably attached to the rear side of casing 21 is a front retainer 25 that elastically holds semiconductor wafers W. This front retainer 25 has, for example a pair of vertically long frames removably attached at both side parts on the rear side of casing 21. The stile of each frame is integrally formed with multiple elastic pieces 26 that are arranged vertically, each obliquely extending toward the center on the rear side of casing 21. Integrally formed at the front end of elastic piece 26 is a small holder block 27 for holding the front rim of semiconductor wafer W by means of a V-groove.

Formed along the periphery on the rear side of casing 21 is a frame-shaped fitting groove. An elastically deformable lip type gasket is snuggly fitted in this fitting groove. This gasket comes into press-contact inside rim flange 12 of container body 1. This gasket is comprised of a frame-shaped base that forms hermetic contact inside rim flange 12 of container body 1, an endless sealing piece that extends from this base and comes into press-contact with rim flange 12 and base-positioning fitting projections that are projected from the base, come into press-contact inside the fitting groove, and formed of predetermined molding material.

The sealing piece of the gasket obliquely extends from its base and appropriately flexes and comes into press-contact with the inner peripheral surface of rim flange 12, to thereby prevent external air from penetrating into the interior of the substrate storing container and hence prevent semiconductor wafers W from contamination, as well as to provide a function of maintaining the oxygen concentration and the relative humidity over a long period of time after purging of air inside the substrate storing container with an inert gas. As the molding material for the gasket, polyester-based, polyolefin-based, polystyrene-based thermoplastic elastomers, fluoro rubber, IR rubber and the like, having a spring hardness (JIS A-hardness) of 80 Hs or lower, measured by JIS K7202, can be considered.

Front plate 22 is given in the form of a laterally long flat plate corresponding to the open front side of casing 21, and formed with pairs of operation ports 28 for locking mechanism 23 and multiple attachment holes, so that the front plate is positioned and fixed to the front side of casing 21 by screwing fixing screws passing through these multiple attachment holes into the screw bosses on casing 21.

Locking mechanism 23 includes: a pair of rotary plates that are disposed left and right and rotationally operated by operational pins of a door opening and closing apparatus that pass through operation ports 28 of front plate 22; a plurality of slide plates that slide upwards and downwards as each rotary plate rotates; and a plurality of engagement claws 29 that are projected from passage holes 24 of casing 21 and engaged into engagement holes of rim flange 12 as each slide plate slides, and is positioned in front of front retainer 25 to assure rigidity of door 20.

With the above, synthetic resin of a type having a water absorption of 0.1 % or lower, a heat distortion temperature of 120 deg.C or higher and outgassing in a total amount of 15 ppm or lower when measured after a 24 hour heating at 80 deg.C by the dynamic headspace technique, is selected as the molding material for molding container body 1 and door 20 of the substrate storing container. Specifically, at least one kind from cycloolefin polymer (COP), liquid crystal polymer (LCP), polyetheretherketone (PEEK), polybutylene terephthalate (PBT) and polyethylene terephthalate (PET), or an alloy resin of these, may be selected.

The reason why the water absorption of the synthetic resin is specified to be 0.1 % or lower is that when the water absorption is 0.1 % or lower, it is possible to maintain the state in which the relativity humidity inside the substrate storing container is 5 % or lower for one hour or longer. In contrast, when the water absorption exceeds 0.1 %, even if the relative humidity in the substrate storing container is reduced to 5 % or lower, it is impossible to keep the relative humidity lower than 5 % over a long period of time because moisture is released from the surface of the substrate storing container.

In View of the water absorption, as the synthetic resin for container body 1 and door 20, cycloolefin polymer or liquid crystal polymer, of which the water absorption can be specified to be 0.02 % or lower, is the best selection. Selection of these makes it possible to keep the state with the relative humidity 5 % or lower for two hours or longer when air inside container body 1 with its open front 6 fitted with door 20 is purged by nitrogen gas or the like so as to make the relative humidity equal to or lower than 5 %.

Since there occurs an anisotropy problem when a liquid crystal polymer is used, it is preferable to add a filler such as conductive carbon fiber or the like in an amount of 10 to 40 wt % as a countermeasure. Further, typically, liquid crystal polymers are classified into two kinds, thermotropic and lyotropic types. The molding material used herein is of the thermotropic type, which is defined as a synthetic resin presenting a liquid crystalline mode in which straight chains of molecules are highly oriented and aligned regularly in a molten state.

Since the thus specified liquid crystal polymer presents goodmoldability, the wall thickness of the substrate storing container can be reduced to less than 4 mm or preferably to 2 to 3 mm. This enables the substrate storing container to be reduced in weight by 10 % or greater.

Further, the liquid crystal polymer forms a two-layered structure composed of a skin layer having a high strength with polymers fully aligned at the time of molding and a core layer enclosed by the skin layer and having a low strength with polymers poorly aligned. Accordingly, as the liquid crystal polymer is made thinner, the ratio of the skin layer becomes greater, hence the strength per unit area becomes greater. It is hence possible to improve the strength of the substrate storing container even if the container is made thinner. Moreover, if a type of polymer having a liquid crystallization temperature of 250 deg. C or higher is used for molding and then annealed, it is possible to markedly reduce the outgas that arises from the substrate storing container during usage.

The synthetic resin is demanded to have a heat distortion temperature of 120 deg. C or higher. This is because when the heat distortion temperature is 120 deg. C or higher, it is possible to prevent the sealability of container body 1 from lowering, and it is possible to expect the effect when air in the substrate storing container is purged by an inert gas or the like.

That is, there is a case in which semiconductor wafers W are thermally processed at a high temperature state and cooled to 80 to 100 deg.C, and then inserted into the substrate storing container to be kept. In this case, if the heat distortion temperature of the synthetic resin is equal to or higher than 120 deg.C, it is possible to eradicate the possibility of deformation at the contact area of supporting pieces 7 and the like of container body 1 with semiconductor wafers W and the fear of deformation of container body 1 due to built-up heat inside the substrate storing container and consequent sealability lowering at front 6 of container body 1. As a result, a higher airtightness can be maintained by the gasket, it is hence possible to expect excellent effect when air in the substrate storing container is purged with an inert gas or dry air.

For the measurement of the total outgas quantity of a synthetic resin, the dynamic headspace technique that is suitable for microanalysis is preferably used. This dynamic headspace technique, differing from other methods such as the static headspace technique and the like, enables approximately total collection of target components, hence it is possible to measure the specimen in minute quantities and expect improvement of detection sensitivity.

In consideration of the above aspects, in order to suppress and prevent deformation accompanied by contact with thermally processed semiconductor wafer W, each supporting piece 7 of container body 1 is molded of molding material containing synthetic resin having a heat distortion temperature of 120 deg.C or higher and a water absorption of 0.1 % or lower. As the synthetic resin for this molding material, at least one kind from cycloolefin polymer, liquid crystal polymer, polyetheretherketone, polybutylene terephthalate and polyethylene terephthalate, or an alloy resin of these, may be selected. Of these, liquid crystal polymer, polyetheretherketone and polybutylene terephthalate are excellent in rigidity and particularly preferable.

Since molding of each supporting piece 7 with the thus specified synthetic resin enables safe holding of semiconductor wafers W on supporting pieces 7, it is possible to prevent displacement of semiconductor wafers W as well as to prevent generation of particles that would exert adverse influence on semiconductor wafers W. In particular, liquid crystal polymer, polyetheretherketone and polybutylene terephthalate are excellent in heat resistance, so that selective use of these to mold supporting pieces 7 makes it possible to reduce generation of organic matter that would be accompanied by contact with thermally treated semiconductor wafers W and hence prevent adherence of organic matter to the semiconductor wafers W.

Other than coil springs and filters, each opening and closing valve 9 of container body 1 is also formed of molding material containing synthetic resin having a heat distortion temperature of 120 deg.C or higher and a water absorption of 0.1 % or lower. As this synthetic resin, at least one kind from cycloolefin polymer, liquid crystal polymer, polyetheretherketone, polybutylene terephthalate and polyethylene terephthalate and polyphenylene sulfide (PPS), or an alloy resin of these, may be used.

Molding opening and closing valve 9 with the molding material containing the above synthetic resin can prevent discharge of moisture into the air at the time of air purging and discharge of moisture into the interior of the substrate storing container, hence making it possible to keep the relative humidity in the substrate storing container to as low as 5 % or lower.

Also as for front retainer 25 of door 20, in order to suppress deformation accompanied by contact with thermally processed semiconductor wafer W, the front retainer is molded of molding material containing synthetic resin having a heat distortion temperature of 120 deg.C or higher and a water absorption of 0.1 % or lower. As the synthetic resin, at least one kind from cycloolefin polymer, liquid crystal polymer, polyetheretherketone, polybutylene terephthalate and polyethylene terephthalate, or an alloy resin of these, may be considered, and in particular, liquid crystal polymer, polyetheretherketone and polybutylene terephthalate are excellent in rigidity and preferable.

The molding material may be composed of the aforementioned synthetic resin alone, but when the substrate storing container is used for in-process operation, it is preferable that an appropriate amount of conductive filler may be added in view of preventing adherence of particles to semiconductor wafers W or damage to semiconductor wafers W due to discharge of static electricity. As the conductive filler,conductivecarbonblack,carbon fiber,carbonnanotube, metal fiber, metal oxide, conductive polymer and the like may be considered. One of these materials may be alloyed with the other material, or these materials may be used in combination.

When, for example, 10 to 30 wt% of carbon fiber is added to a synthetic resin selected from the above-described group of synthetic resin, the volume resistance of the substrate storing container can be specified to be 10⁸ Ω or lower, preferably 10⁶ Ω or lower. Specifying the volume resistance of the substrate storing container to be equal to 10⁸ Ω or lower in this way, makes it possible to prevent particles from adhering to semiconductor wafers W accommodated in the substrate storing container and prevent damage to semiconductor wafers W accompanied by discharge of static electricity.

According to the above configuration, since the synthetic resin in the molding material of the substrate storing container employs a synthetic resin with a low water content, when the relative humidity inside the substrate storing container has been reduced down to 1 % by purging the interior of the substrate storing container with nitrogen gas (with a purity of 99. 999%), the substrate storing container is left after stoppage of the air purging and then the relative humidity is measured by a preset hygrometer inside the substrate storing container, it is possible to maintain this humidity for one hour or longer. Accordingly, the humidity inside the substrate storing container can be kept low, so that it is possible to prevent semiconductor wafers W from contamination, and even after circuit patterns have been formed on the surface of semiconductor wafers W the circuit patterns can be kept from being corroded during storage.

Further, container body 1 and door 20 that have areas connecting from the external surface to the internal surface of the substrate storing container, and opening and closing valves 9 are formed of a molding material having a water absorption of 0.1 % or low and outgassing in a total amount of 15 ppm when measured by the dynamic headspace technique after a 24 hour heating at 80 deg.C while multiple supporting pieces 7 and front retainer 25 that come in contact with semiconductor wafers W are formed of a molding material having a water absorption of 0.1 % or low and outgassing in a total amount of 15 ppm when measured by the dynamic headspace technique after a 24 hour heating at 80 deg.C. Accordingly, it is possible to keep the relative humidity inside the substrate storing container to as low as 5 % or lower, over a long period.

Further, as themoldingmaterial, if amoldingmaterial having a heat distortion temperature of 120 deg.C or higher, in addition to the above properties is selected, it is possible to effectively suppress and prevent loss of sealability of the substrate storing container and hence keep the relative humidity of the substrate storing container at the low level for a longer period of time.

It is understood that if the sealability of the substrate storing container is not good enough, external air penetrates into the substrate storing container, so that it is difficult to keep the relative humidity inside the substrate storing container low. Therefore, it is preferably that, when the substrate storing container is set in an airtight chamber, and these are decompressed to -0.3 kPa and -30 kPa, respectively, and evolution of the inner pressure of the substrate storing container is observed, the decompressed state of the substrate storing container can be hermetically maintained.

Further, though in the above embodiment multiple supportingpieces 7 are arrayed on both side walls 5 of container body 1, multiple supporting pieces 7 may be integrally molded on both side walls 5 of container body 1, or separate supporting pieces 7 may be attached afterwards to both side walls 5 of molded container body 1. Bottom plate 10 of container body 1 may be formed of the same molding material as opening and closing valve 9, or may be omitted.

Further, front retainer 25 of the above embodiment may be formed of a vertically long frame that is removably attached to the center on the rear side of casing 21, a plurality of elastic pieces 26 vertically arrayed and suspended between a pair of stiles of this frame and holding blocks 27, each being formed in individual elastic piece 26 and holding the peripheral edge in the front of semiconductor wafer W with a V-groove.

Next, examples of the present invention will be described with a comparative example.

### [Examples]

### • Measurement of the relative humidity inside the substrate storing container

The container body shown in FIGS. 1 and 2, the supporting pieces, opening and closing valves, door and front retainer were formed of respective molding materials shown in Table 1, to prepare substrate storing containers of examples 1, 2 and 3.

After production of the substrate storing containers of examples 1 and 2 and 3, the interior of the hermetically sealed substrate storing container was purged by nitrogen gas with a purity of 99.999% to reduce the relative humidity inside the substrate storing container down to 1 %, then the air purging was stopped. After letting the substrate storing container alone, the humidity was measured by a humidity sensor preset inside the substrate storing container, to thereby measure the time at which the relative humidity inside the substrate storing container exceeds 5 %. The measurements are shown in Table 2.

### • Measurement of resistivity

The surface resistance of each of substrate storing containers of examples 1, 2 and 3 was measured by a resistance meter (Model 5501DM: a product of SANWA M.I. TECHNOS CO., LTD) and the result is shown in Table 2. The surface resistance of the substrate storing container was measured conforming to ASTM D257, under an environment with a temperature of 24 deg. C and a humidity of 50 %.

### • Measurement of total outgas quantity

In order to measure the amount of outgas from the molding material of each of the substrate storing containers of examples 1, 2 and 3, outgas arising when 0.1g of pellet material is heated at 80 deg.C over 60 minutes under circulation of high-purity helium by the dynamic headspace technique, was collected and the collected gas was analyzed by gas chromatography. Then, the total amount of outgas was measured and quantiated using n-decane as a reference material. The result is shown in Table 2.

### [Comparative Example]

The container body shown in FIGS. 1 and 2, the supporting pieces, opening and closing valves, door and front retainer were formed of respective molding materials shown in Table 1, to prepare a substrate storing container of a comparative example. After production of the substrate storing container of the comparative example, the relative humidity inside the substrate storing container, the resistivity and the total amount of outgas were measured in the same manner as the examples. The result is shown in Table 2.

**[Table 1]**

| | Container Body | Door | Supporting Piece | Front Retainer | Opening/ Closing Valve |
|---|---|---|---|---|---|
| Example 1 | | | | | |
| Synthetic Resin | COP | COP | PBT | PBT | COP |
| Water Absorption(%) | <0.01 | <0.01 | 0.08 | 0.08 | <0.01 |
| Heat Distortion Temperature (Deg.C) | 123 | 123 | 205 | 205 | 123 |
| Example 2 | | | | | |
| Synthetic Resin | LCP+ Conductive CF15wt% | LCP+ Conductive CF15wt% | LCP+ Conductive CF15wt% | PEEK | COP |
| Water Absorption(%) | 0.02 | 0.02 | 0.02 | 0.08 | <0.01 |
| Heat Distortion Temperature (Deg.C) | 305 | 305 | 305 | 315 | 123 |
| Example 3 | | | | | |
| Synthetic Resin | LCP+ Conductive CF15wt% | COP | PEEK | PET | PPS |
| Water Absorption(%) | 0.02 | <0.01 | 0.08 | 0.08 | 0.02 |
| Heat Distortion Temperature (Deg.C) | 305 | 123 | 315 | 226 | 260 |
| Comparative Example | | | | | |
| Synthetic Resin | PC+ Conductive CF10wt% | PC | PC+ Conductive CF10wt% | PEEK | PC |
| Water Absorption(%) | 0.24 | 0.24 | 0.24 | 0.08 | 0.24 |
| Heat Distortion Temperature (Deg.C) | 130 | 127 | 130 | 315 | 127 |

**[Table 2]**

| | Surface Resistance (Ω) | Total Outgas quantity (ppm) | Maintained time at a relative humidity of 5% |
|---|---|---|---|
| Example 1 | 10¹² | 5 | 120 |
| Example 2 | 10⁴ | 0.3 | 120 |
| Example 3 | 10⁴ | 2 | 120 |
| Comparative Example | 10⁵ | 20 | 10 |

The substrate storing containers of examples 1, 2 and 3 were measured as to relative humidity, resistance and total outgas quantity, and very satisfactory result could be obtained. In contrast to this, the substrate storing container of the comparative example could not present a satisfactory result.

### Description of Reference Numerals

- 1: container body
- 2: bottom plate
- 3: top plate
- 4: rear side wall
- 5: side wall
- 6: front
- 7: supporting piece (supporter)
- 9: opening and closing valve
- 12: rim flange
- 20: door element
- 21: casing
- 22: front plate
- 23: locking mechanism
- 25: front retainer (retainer)
- W: semiconductor wafer (substrate)

## Claims

1. A substrate storing container comprising: a container body for accommodating substrates; and a door that is detachably fitted to an opening of the container body with a gasket interposed therebetween, the container body and door being separately formed of molding material containing synthetic resin having a water absorption of 0.1 % or lower and outgassing in a total amount of 15 ppm or lower whenmeasured after a 24 hour heating at 80 deg.C by the dynamic headspace technique, **characterized in that**
the synthetic resin in the molding material is at least one kind selected from cycloolefin polymer, liquid crystal polymer, polyetheretherketone, polybutylene terephthalate and polyethylene terephthalate, or an alloy resin of these.

2. The substrate storing container according to Claim 1, wherein when air inside the container body with the door fitted to the opening is purged so as to make the relative humidity 5 % or lower, the state in which the relative humidity is 5% or lower can be maintained for two hours or longer.

3. The substrate storing container according to Claim 1 or 2, wherein the heat distortion temperature of the synthetic resin of the molding material is specified to be 120 deg.C or higher.

4. The substrate storing container according to Claim 1, 2 or 3, further comprising a supporting structure disposed in the container body for supporting substrates, wherein the supporting structure is formed of molding material containing synthetic resin having a heat distortion temperature of 120 deg.C or higher and a water absorption of 0.1 % or lower and the synthetic resin of the molding material is composed of at least one kind selected from cycloolefin polymer, liquid crystal polymer, polyetheretherketone, polybutylene terephthalate and polyethylene terephthalate, or an alloy resin of these.

5. The substrate storing container according to any one of Claims 1 to 4, further comprising opening and closing valves for air replacement, attached to the container body, wherein part of the opening and closing valve is formed of molding material containing synthetic resin having a heat distortion temperature of 120 deg.C or higher and a water absorption of 0.1 % or lower and the synthetic resin of the molding material is composed of at least one kind selected from cycloolefin polymer, liquid crystal polymer, polyetheretherketone, polybutylene terephthalate, polyethylene terephthalate and polyphenylene sulfide or an alloy resin of these.

6. The substrate storing container according to any one of Claims 1 to 5, wherein the door has a substrate holding retainer attached thereto, the retainer is formed of molding material containing synthetic resin having a heat distortion temperature of 120 deg.C or higher and a water absorption of 0.1 % or lower, and the synthetic resin of the molding material is composed of at least one kind selected from cycloolefin polymer, liquid crystal polymer, polyetheretherketone, polybutylene terephthalate and polyethylene terephthalate, or an alloy resin of these.
